# EUROPEAN PATENT APPLICATION

(11) **EP 2 180 529 A1**
(43) Date of publication of application: **28.04.2010**
(21) Application number: 08018397.3
(22) Date of filing: 21.10.2008
(51) Int. Cl.: H01L 31/18, H01L 31/0224

(54) **Transparent conductive zinc oxide film and production method thereof**

(71) Applicant: Applied Materials, Inc., Santa Clara, CA 95054-3299 (US)
(72) Inventor: Graw, Oliver, 63755 Alzenau (DE); Schreiber, Udo, 63637 Jossgrund (DE)
(74) Representative: Bockhorni, Josef

(57) **Abstract**

The present invention concerns a method for the generation of a transparent conductive oxide coating (TCO layer), in particular a transparent conductive oxide coating as a transparent contact for solar cells, flat panel displays and the like. The TCO layer is generated by depositing zinc oxide and additionally aluminium, indium, gallium, boron, nitrogen, phosphorous, chlorine, fluorine or antimony or a combination thereof, with the process atmosphere containing hydrogen. These TCO layers can be realized in a particularly simple and cost-effective way compared to ITO. The properties of the inventive TCO layers are nearly as good as those for ITO, regarding high transmittance and low resistance.

## Description

The present invention concerns a method for the generation of a transparent conductive oxide coating in accordance with the generic term of claim 1, a transparent conductive oxide coating in accordance with the generic term of claim 8 and a use of a transparent conductive oxide coating in accordance with the generic term of claim 10.

Transparent conductive contacts are especially needed for photovoltaic applications, such as solar cells and solar modules. For this, mostly transparent conductive oxide coatings (TCO layers) are used, with indium tin oxide (ITO) having been mostly used so far. Furthermore, ITO is established in display market for many years, especially for flat panel displays. In the meanwhile, however, zinc oxide (ZnO) is enjoying great popularity for industrial use, since it is above all more economical to deposit than ITO, because the price for target material is lower for ZnO.

Unfortunately, ZnO has a higher resistance compared to ITO and great efforts have been made to reduce its resistance. In this regard, it is well-known that especially a two-part structure of the zinc oxide- based TCO layer exhibits optical and electrical characteristics that are comparable to those of an ITO layer. From US 5,078,804 is known a structure with a first ZnO layer of high electrical resistance (low conductivity) and a second ZnO layer of low electrical resistance (high conductivity), with the first ZnO layer arranged on a buffer layer covering the absorber range of a copper indium gallium diselenide (CIGS). Both ZnO layers are deposited by RF magnetron sputtering in an oxygen-argon atmosphere or a pure argon atmosphere. Further, US 2005/0109392 A1 discloses a CIGS solar cell structure, in which the buffer layer is likewise covered with a so-called intrinsic, i.e. pure ZnO layer (i-ZnO), which exhibits a high electrical resistance, and upon which is subsequently applied a ZnO layer, which is doped with aluminum and exhibits low electrical resistance. The i-ZnO-layer is deposited by RF magnetron sputtering and the ZnO layer of high conductivity is deposited by magnetron sputtering of an aluminum-doped ZnO target. This aluminum-doped ZnO target can also be DC sputtered, which substantially increases the coating rate relative to RF sputtered targets. DC sputtering is in industrial use for deposition of these conductive ZnO:Al layers. Disadvantageous in such a TCO layer is the fact that it must be structured. Resistances of 500 µΩ cm to 1000 µΩ cm are reachable for high depositing temperatures of 350°C and more. Furthermore, conductivity of doped ZnO is limited for lower temperatures and transmittance of ZnO may be influenced unfavorable by dopants.

The object of the present invention is therefore to make a procedure available, with which TCO layers of ZnO are producible that have high conductivity as well as high transparency without the need of special structuring and, in particular, which are reachable for temperatures below 350°C. In particular, resistance and transparency of the coating should be comparable to and preferably transmittance should be better than those of ITO.

This object is achieved by a method in accordance with claim 1, a TCO layer in accordance with claim 8 and a use thereof in accordance with claim 10. Advantageous embodiments of these objects are the subject of the dependent claims.

The inventive method is characterized by the fact that the transparent conductive oxide coating is generated by depositing zinc oxide and additionally aluminium, indium, gallium, boron, nitrogen, phosphorous, chlorine, fluorine or antimony or a combination thereof, with the process atmosphere including hydrogen. Gallium is the most preferred dopant. In that way ZnO layers doped with aluminium, indium, gallium, boron, nitrogen, phosphorous, chlorine, fluorine or antimony or a combination thereof (ZnO:X layer) will be produced.

The inventors have surprisingly found that, because of the hydrogen content in the process atmosphere, ZnO:X layers of low resistance and high transmittance can be manufactured and these properties are comparably good as these for ITO and for transmittance it may be better. Because the price for ZnO targets is much lower than the price for ITO targets, processing costs for TCO layers are much reduced, but TCO layer properties and layer quality is nearly held constant.

These inventive TCO layers may be deposited directly onto a substrate, like glass, resin and the like, or onto other layers, like functional layers of solar cells or displays.

In a particularly preferred embodiment, the hydrogen content in the process atmosphere is in the range from 1 vol. % to 50 vol. %, in particular in the range from 4 vol. % to 16 vol. % and preferably in the range from 6 vol. % to 12 vol. %.

Advantageously, the substrate temperature during deposition is at most 350°C, in particular, is in the range from 100°C to 250°C and preferably is 230°C. In these temperature ranges for instance displays are producible comprising resin colour filters having a critical temperature of 250 °C and being damaged above that temperature. Advantageously, hydrogen content in the process atmosphere leads for low temperatures to a resistance as low as for gallium doped ZnO at temperatures of at least 350°C. There are different temperature regimes useable: cold depositing with successive tempering or warm depositing, with warm depositing possibly preceded by preheating. For the inventive method warm deposition is preferred and in particular a temperature ramp is used during deposition.

Usable deposition methods are chemical vapor deposition, physical vapor deposition, such as sputtering and the like, with DC sputtering mostly preferred, because of its high production throughput, good layer quality and low equipment costs. If the TCO layer is generated by means of pulsed DC sputtering, process stability can be improved and thus the deposition rate can be advantageously further increased, since higher power densities are possible. An increase in process stability can also be obtained by the use of medium frequency sputtering (MF-sputtering) of at least two targets. By DC sputtering in the context of the present invention is therefore meant DC sputtering, pulsed DC sputtering and MF-sputtering.

Preferably, the power density for DC sputtering is in the range from 2 W/cm² to 20 W/cm², in particular in the range from 4 W/cm² to 15 W/cm² and preferably in the range from 6 W/cm² to 11 W/cm². For these power densities the resistance is improved as well as the deposition rate.

For further improving and adjusting resistance and transmittance the process atmosphere could further contain oxygen.
If a hydrogen source is used, which contains a gas mixture containing hydrogen or a hydrogen compound, the amount of hydrogen can be controlled more precisely by using a larger mass flow controller (MFC). If a hydrogen source is used containing a chemical compound containing hydrogen, processing of hydrogen, in particular in connection with oxygen, is safer.

Independent protection is sought for a transparent conductive oxide coating comprising ZnO doped with aluminium, indium, gallium, boron, nitrogen, phosphorous, chlorine, fluorine or antimony or a combination thereof, the resistance of the coating is at most 1000 µΩ cm, in particular at most 600 µΩ cm and preferably at most 450 µΩ cm and the coating is depositable at temperatures below 350°C, in particular produced with the method of the present invention.

In a preferred embodiment the transparent conductive coating has a transmittance of at least 96,5 %, in particular at least 97,5 % and preferably at least 98,7 % at a wavelength of 550 nm.

Independent protection is sought for a use of the transparent conductive coating of the present invention for a transparent contact for solar cells, displays and the like. Preferably, the transparent contact is only consisting of the transparent conductive coating.

Features and further advantages of the present invention are apparent from the following description of the embodiments illustrated in the drawing. In purely schematic form,
- Fig. I: illustrates the dependence of the resistivity on the hydrogen content of the process gas atmosphere for ZnO:Ga layers generated by DC sputtering,
- Fig. 2: illustrates the dependence of the resistivity on the power density for ZnO:Ga layers generated by DC sputtering,
- Fig. 3: illustrates the dependence of the dynamic sputter rate on the power density for ITO and ZnO:Ga layers generated by DC sputtering, and
- Fig. 4: illustrates the dependence of the transmittance on the wavelength compared for a ZnO:Ga layer generated by DC sputtering according to the inventive method and for ZnO:Ga and ITO layers deposited without hydrogen.

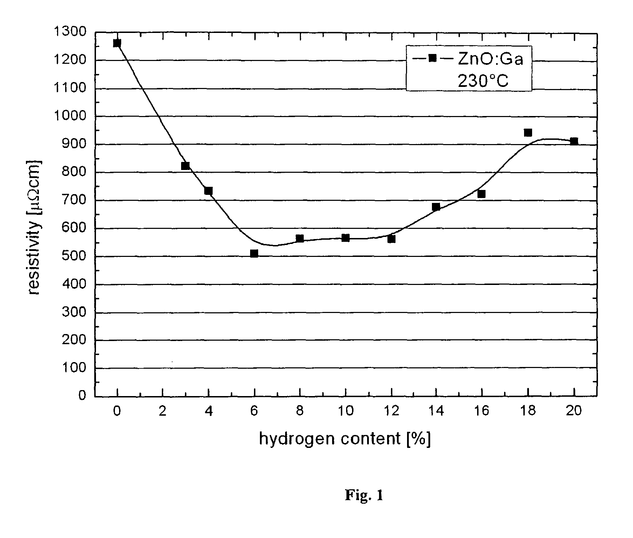

Fig. 1 shows the dependence of the resistance on the hydrogen content of the process gas atmosphere for ZnO:Ga layers, which were manufactured in the inventive method by means of DC sputtering. The ZnO:Ga layers were deposited with a thickness of about 150 nm onto a glass substrate from a planar target with a power density of about 2 W/cm². Of course, rotatable targets are useable too. A ceramic target containing both zinc oxide and gallium is used advantageously as the target for DC sputtering. Such a target is mixed ceramic, which is typically producible by compression or sintering. Alternatively, metallic targets are also usable which consist of a Zn-Ga alloy with several wt. % gallium. Through addition of oxygen, ZnO:Ga can be sputtered herefrom in the reactive process.

Fig. 1 illustrates the huge influence of hydrogen content during DC sputtering. In this embodiment, hydrogen significantly decreases resistance from about 1270 µΩ cm for ZnO:Ga sputtered without hydrogen to about 500 µΩ cm to 600 µΩ cm. There exist a broad minimum in resistance for hydrogen contents between 4 vol. % and 16 vol. %. Advantageously, hydrogen has no negative influence to transmittance of the TCO layer. To the contrary, increasing the hydrogen content in process atmosphere will lead to a slightly improvement in transmittance.

To explain the positive influence of hydrogen, it is assumed that the dopant gallium would improve conductivity of ZnO but produces lattice defects which increase resistance and hydrogen may passivate these defects so that the resistance decreases significantly. Furthermore it is well established in literature that hydrogen acts as a donor in ZnO providing additional charge carriers to the conduction band.

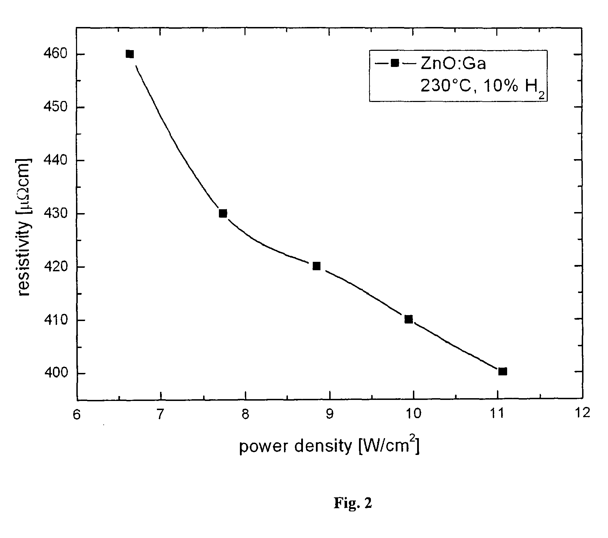

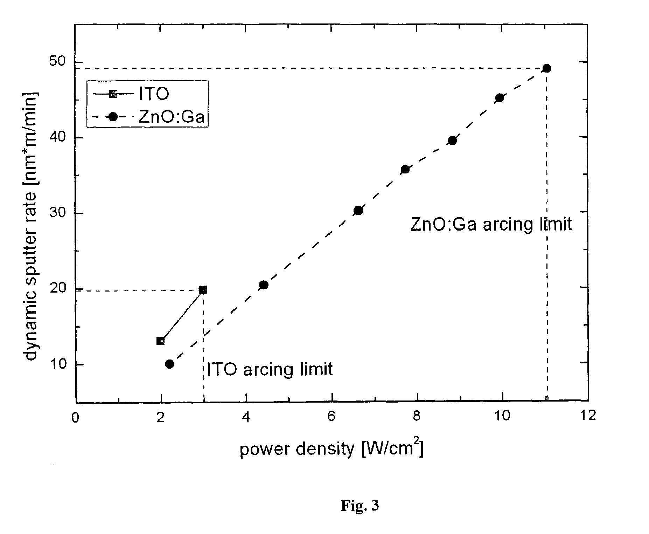

Fig. 2 shows the dependence of the resistance on the power density of DC sputtering for ZnO:Ga layers. The ZnO:Ga layers in this embodiment were deposited with a thickness of about 300 nm onto a glass substrate from a planar target with a hydrogen content in the process atmosphere of 10 vol. %. It becomes clear that increasing power density further reduces resistance of the TCO layer. For ZnO:Ga with 10 % hydrogen a resistance of less than 450 µΩ cm is reachable and for a power density of about 10 W/cm² the resistance is about 400 µΩ cm. This fact is important, since a higher power density is followed by a higher sputter rate (see Fig. 3) and better layer quality. Furthermore, with a higher sputter rate the number of cathodes used in the deposition process may be reduced or, alternatively, the process speed may be enhanced, because for in line-processing the processing speed must be equal for each process stage, i.e. locking-in stage, preprocessing stage, DC sputtering, locking-out stage and so on and deposition always has the slowest processing speed and thus defines the over all throughput.

Fig. 3 shows the dependence of the dynamic sputter rate on the power density for ITO (light squares) and ZnO (dark dots) layers generated by DC sputtering without hydrogen within the process atmosphere. Vertical and horizontal lines indicate the arcing limit, i.e. the limit within no arcing occurs and arcing reduces layer quality and reproducibility. For ZnO the arcing limit is more than three times higher (about 11 W/cm²) than for ITO (about 3 W/cm²) and for ZnO dynamic sputter rates of about 50 nm m/min are reachable instead of about 20 nm m/min for ITO. That means, even if the sputter rate is higher for ITO than for ZnO for a given power density, the absolutely possible sputter rate within the arcing limit is higher for ZnO than for ITO. Therefore, processing TCO layers of ZnO is much cheaper than for ITO, because the number of cathodes may be reduced or the process speed may be increased and ZnO targets are cheaper than ITO targets.

Dynamic sputter rates of ZnO: Ga without hydrogen are about 10% higher than for ZnO:Ga with hydrogen for equal power densities.

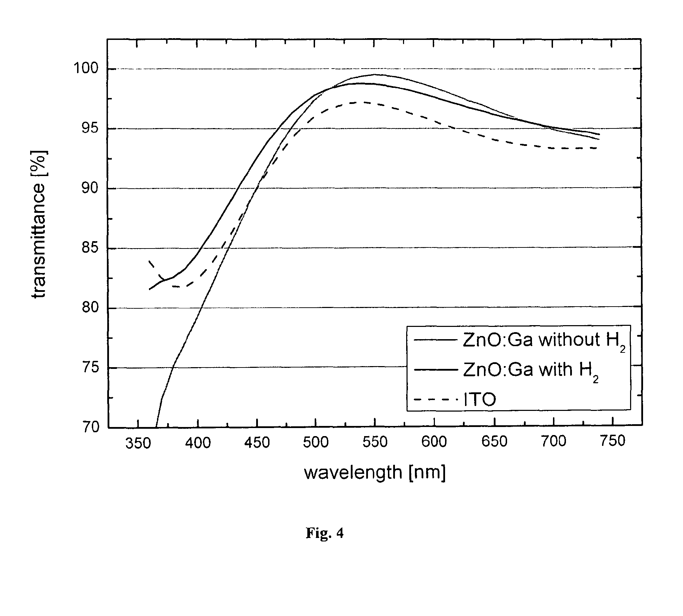

Fig. 4 shows dependence of transmittance on wavelength compared for ZnO:Ga with and without hydrogen and for ITO. All layers are deposited with layer thicknesses of about 150 nm onto a glass substrate.

A ZnO:Ga (dark straight line) layer was deposited by DC sputtering with 10 vol. % hydrogen within the process atmosphere. A further ZnO:Ga layer (light straight line) was deposited without hydrogen within the process atmosphere. Both layers were deposited at 230°C. It is clearly to see that hydrogen greatly improves transmittance in the region of short wavelengths, and only reduces the maximum transmittance slightly in the region about 550 nm from about 99,50 % for ZnO:Ga without hydrogen at 550 nm to about 98,78 % for ZnO:Ga with hydrogen at 540 nm.

Comparing the ZnO:Ga layer deposited by DC sputtering with 10 vol. % hydrogen within the process atmosphere with ITO (dark dashed line), also deposited at 230°C, it can be seen that ZnO:Ga has an excellent transmittance peak of about 98,8% at 540 nm, which is about 1,6% higher than for ITO (97,2 % at 540 nm). The transmittance of ZnO:Ga with hydrogen is higher than the transmittance of ITO over the complete visible range of wavelength (350nm to 750nm), so that the transmittance colour of this coating is more neutral than that of ITO. In contrast, the ZnO:Ga layer deposited by DC sputtering without hydrogen has a transmittance for short wavelength even worse than for ITO. Transmittance peaks for all layers are shown in Table 1.

**Table 1:**

| Material | Wavelength [nm] | Maximum transmittance [%] |
|---|---|---|
| ZnO:Ga without H2 | 550 | 99,50 |
| ZnO:Ga with H2 | 540 | 98,78 |
| ITO | 540 | 97,20 |

Advantageously, transmittance for ZnO:Ga with hydrogen in process atmosphere is only slightly depending from deposition temperature, with slightly better transmittance for higher temperatures.

For ZnO: Al, i.e. aluminum doped zinc oxide, results of comparative measurements are shown in Table 2. In both samples, hydrogen content in process atmosphere was 14%, but substrate temperatures were different.

**Table 2:**

| Material | Temperature | H2 content | Power density | Resistance |
|---|---|---|---|---|
| ZnO:Al with H2 | 230°C | 14% | 8,9 W/cm² | 780 µΩ cm |
| ZnO:Al with H2 | 350°C | 14% | 9,3 W/cm² | 650 µΩ cm |

From the above mentioned deliberations, it is clear that, with the aid of the present invention, TCO layers that have a high transmittance and low resistance can be realized in a particularly simple and cost-effective way compared to ITO. As a result, solar cells, in which these TCO layers can be used as transparent electrically conductive contacts, can be generated much more cost effectively. These TCO layers can also be used in other devices like displays and so on.

It is to be understood that the present invention is not limited to the embodiment(s) described above and illustrated herein, but encompasses any and all variations falling within the scope of the appended claims. For example, while all results are described in connection with gallium doped zinc oxide, it will be apparent to those skilled in the art that other common dopants are useable, like aluminium, indium, boron, nitrogen, phosphorous, chlorine, fluorine or antimony and so on, or combinations thereof.

## Claims

1. A method for generating a transparent conductive oxide coating, especially a transparent conductive oxide layer for transparent contacts for solar cells, displays and the like by depositing doped zinc oxide,
**characterized by the fact that**
the transparent conductive oxide coating is generated with the process atmosphere including hydrogen.

2. The method in accordance with claim 1,
**characterized by the fact that**
the hydrogen content in the process atmosphere is in the range from 1 vol. % to 50 vol. %, in particular in the range from 4 vol. % to 16 vol. % and preferably in the range from 6 vol. % to 12 vol. %.

3. The method in accordance with any of the previous claims,
**characterized by the fact that**
the substrate temperature during deposition is at most 350°C, in particular, is in the range from 100°C to 250°C and preferably is 230°C.

4. The method in accordance with any of the previous claims,
**characterized by the fact that**
the transparent conductive oxide coating is generated by means of sputtering, in particular DC sputtering, pulsed DC sputtering or MF sputtering.

5. The method in accordance with claim 4,
**characterized by the fact that**
the power density is in the range from 2 W/cm² to 20 W/cm², in particular in the range from 4 W/cm² to 15 W/cm² and preferably in the range from 6 W/cm² to 11 W/cm².

6. The method in accordance with any of the previous claims,
**characterized by the fact that**
the hydrogen is provided by a hydrogen source, the source containing pure hydrogen, a gas mixture containing hydrogen or a chemical compound containing hydrogen, in particular H₂O, NH₃ or CH₄.

7. The method in accordance with any of the previous claims,
**characterized by the fact that**
the process atmosphere is further containing oxygen, a gas mixture containing oxygen or any chemical compound containing oxygen.

8. The method in accordance with any of the previous claims,
**characterized by the fact that**
the dopant is aluminium, indium, gallium, boron, nitrogen, phosphorous, chlorine, fluorine or antimony or a combination thereof, preferably gallium.

9. A transparent conductive oxide coating comprising zinc oxide and a dopant,
**characterized by the fact that**
the resistance of the coating is at most 1000 µΩ cm, in particular at most 600 µΩ cm and preferably at most 450 µΩ cm and the coating being depositable at temperatures below 350°C, in particular produced with the method in accordance with any of the previous claims.

10. The transparent conductive coating in accordance with claim 9,
**characterized by the fact that**
the transmittance of the coating is at least 96,5 %, in particular at least 97,5 % and preferably at least 98,8 % at a wavelength of 540 nm.

11. A use of a transparent conductive coating in accordance with claims 9 or 10,
**characterized by the fact that**
the transparent conductive coating is used for a transparent contact for solar cells, displays and the like.

12. The use in accordance with claim 11,
**characterized by the fact that**
the transparent contact is only consisting of the transparent conductive coating.
